# EUROPÄISCHE PATENTSCHRIFT

(11) **EP 1 367 877 B1**
(45) Veröffentlichungstag und Bekanntmachung des Hinweises auf die Patenterteilung: **22.12.2004**
(21) Anmeldenummer: 02011735.4
(22) Anmeldetag: 27.05.2002
(51) Int. Cl.: H05K 7/20, F24F 13/22

(54) **Klimatisierungssystem, insbesondere für Schaltschränke**
Air conditioning system, in particular for electrical cabinets
Système de conditionnement d'air, en particulier pour armoires électriques

(43) Veröffentlichungstag der Anmeldung: 03.12.2003
(73) Patentinhaber: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(56) Entgegenhaltungen:
- DE-A- 19 951 921
- US-A- 4 424 686
- US-A- 5 036 677
- US-A- 5 638 695
- US-B1- 6 308 526

## Beschreibung

Die Erfindung betrifft ein Klimatisierungssystem für Schränke zur Aufnahme von Steuerungs- und Automationssysteme sowie für die Netzwerktechnik, insbesondere Schaltschränke, mit einer Kühlvorrichtung gemäß dem Oberbegriff des Anspruches 1.

Bei in einem Gehäuse angeordneten Bauteilen, welche entsprechende Abwärme erzeugen, ist es notwendig, die Abwärme aus dem Gehäuse abzuführen und eine Temperatur in dem Gehäuse durch mehr oder weniger starkes Einblasen oder Absaugen von Umgehungsluft in den Gehäuseinnenraum mittels eines Lüfters zu kontrollieren. Bekannterweise werden derartige Gehäuse mit einem Filterlüfter versehen, welcher entweder ständig läuft oder von einer Steuerung in Abhängigkeit von einer Temperatur im Gehäuse an- und abgeschaltet wird. Der Filterlüfter ist in einer Ausnehmung einer Wandung des Gehäuses des Schaltschrankes angeordnet und beispielsweise mittels Schraubverbindung fixiert. Gleichzeitig sind an einer anderen Stelle des Gehäuses für einen Luftaustritt entsprechende Luftaustrittsschlitze vorgesehen.

Darüberhinaus ist es bekannt, Schaltschränke mit Kühlvorrichtungen zu versehen, die außen- oder innenseitig einem Schaltschrank angeordnet sind. Mittels dieser Kühlvorrichtung wird aus dem Innenraum des Schaltschrankes abgesogene Warmluft über ein Kühlaggregat geleitet und die somit erzeugte Kaltluft wieder in den Innenraum des Schaltschrankes geleitet.

Ein Klimatisierungssystem mit den Merkmalen des Oberbegriffes des Anspruches 1 ist durch die US-A-6 308 526 bekannt. Dieses Klimatisierungssystem umfasst ein Klimatisierungsgerät, bei dem ein Gehäuse mit einer Montageplatte vermittels Befestigungsklammem verbunden ist, wobei die Montageplatte an einem elektrischen Geräteschrank angebracht wird. Durch Schwerkraft und vermittels Verriegelungsschrauben wird das Gehäuse an der Montageplatte befestigt. Nach der Befestigung des Gehäuses an der Montageplatte werden die Montageplatte und die Befestigungsklammem durch das Gehäuse und den Schrank verdeckt. Die Befestigungsklammer ist eine Kombination von Haken und Schlitzen. Plattenteile des Gehäuses sind unter Verwendung einer Kombination von Haken und Schlitzen mit Dichtungen, die zwischen den Tafeln zusammengedrückt werden, miteinander verbunden. Das Gehäuse umfasst femer einen horizontal angeordneten Verdampfer zwischen einem Verdampfergebläse und einem Kondensatorgebläse. Klimatisierungsteile sind innerhalb des Gehäuses vertikal gestapelt. Die Luftströmung im Gehäuse ist im Allgemeinen aufwärts, sowohl in den Innen- als auch in den Außenströmungsbereichen. Kondensat, das sich auf dem Verdampfer bildet, wird innerhalb des Gehäuses verdampft und mit dem Heißabluftstrom nach außen abgegeben. Ein Abluftgitter lenkt die Abluftströmung von abwärts nach im Wesentlichen horizontal um, um die Mischung von Zu- und Abluft zu reduzieren.

Die US-A-4 424 686 offenbart eine bodenmontierbare Klimaanlage, die ein Gehäuse umfasst, das Kondensatorschlangen in konischer Anordnung um eine vertikale Achse und zylindrisch angeordnete Verdampferschlangen, die koaxial über den Kondensatorschlangen angeordnet sind, aufnimmt. Ein Tropfenauffänger trennt die Kondensatorschlangen von den Verdampferschlangen und weist Öffnungen zur Ableitung von Kondensat auf die Kondensatorschlangen als Verflüssiger zur Verdampfung auf. Ein mit einer Bodenleitung, die für den Einbau in eine Montageöffnung im Boden eines Raumes eingerichtet ist und ein verbundener Kondensatorventilator treibt Heißluft durch die Montageöffnung und ein Verdampferventilator ist mit einer oberen Leitung verbunden, um kühle Luft in den gekühlten Raum zu treiben. Ein anderer Ventilator ist vorgesehen, um kühle Luft über den Kompressor zu treiben. Diese Klimaanlage ist nicht als Kühlvorrichtung für Schaltschränke vorgesehen.

Die bekannten Kühlvorrichtungen arbeiten nur mit einem Verdampfer, wobei unterhalb des Verdampfers ein Verflüssiger angeordnet ist, dem das Kondensat zum Verdampfen zugeführt wird. Dabei ist der Verdampfer derart angeordnet, dass die gesamte, Kondensat abgebende Fläche oberhalb des Verflüssigers liegt.

Es ist Aufgabe der vorliegenden Erfindung, ein Klimatisierungssystem mit einer Kühlvorrichtung gemäß der eingangs genannten Art zu schaffen, die als Dach- oder Innenraum- oder Sockelklimagerät, insbesondere bei Schaltschränken eingesetzt werden kann, wobei anfallendes Kondensat einer Verdunstung zugeführt wird. Darüberhinaus sollte die Kühivorrichtung kleinste Abmessungen aufweisen und darüberhinaus an jede Schaltschrankbreite anpassbar sein.

Gelöst wird diese Aufgabe durch ein Klimatisierungssystem mit den Merkmalen des Anspruches 1.

Das erfindungsgemäße Klimatisierungssystem, insbesondere für Schaltschränke, besteht darin, dass das Klimatisierungssystem ein oder mehrere, vorzugsweise in der Ebene des Gebläses liegende Verdampfer aufweist, wobei unterhalb der Verdampfer der Verflüssiger derart angeordnet ist, dass die in einem Abstand voneinander angeordneten Verdampfer mit einem Abschnitt bzw. mit ihren vorderen Bereichen oberhalb des Verflüssigers zu liegen kommen, so dass das von den Verdampfem in deren oberhalb des Verflüssigers liegenden Bereichen abgegebene Kondensat auf den Verflüssiger tropft und verdampft bzw. verdunstet.

Nach einer weiteren Ausführungsform der Erfindung besteht die Kühlvorrichtung für dieses Klimatisierungssystem aus einer oberen Trägerplatte, einer unteren Trägerplatte und einem beide Trägerplatten abdeckenden, kastenförmigen haubenartigen Abdeckgehäuse. Auf der oberen Trägerplatte mit einer mittigen oder außermittigen Durchbrechung sind im Bereich dieser Durchbrechung ein Gebläse, wie z. B. Radiallüfter, und zu beiden Seiten des Gebläses im Abstand voneinander je ein Verdampfer angeordnet. Die untere Trägerplatte ist mittig oder außermittig mit einem in die Durchbrechung in der oberen Trägerplatte mündenden, mit dem Innenraum des Schaltschrankes in Verbindung stehenden Zuführungsstutzen für die Zuführung der Warmluft aus dem Innenraum des Schaltschrankes zu den beiden Verdampfern versehen. Außerdem trägt die untere Trägerplatte einen Verflüssiger, dem ein Verflüssigerlüfter, z. B. Axiallüfter, an der an der unteren Trägerplatte vorgesehenen Rückwand zugeordnet ist, wobei der Verflüssiger quer zu den beiden Verdampfern liegend ist. Außerdem wird dem Verflüssiger vermittels des Verflüssigerlüfters Umgebungsluft zugeführt und aus diesem abgeleitet. Die obere Trägerplatte ist über der unteren Trägerplatte derart angeordnet, dass die beiden Verdampfer zur Kondensatverdunstung mit ihren beiden vorderen Bereichen oberhalb des Verflüssigers zu liegen kommen, wobei die obere Trägerplatte gegenüber der unteren Trägerplatte derart bemessen ist, dass die vorderen Bereiche der beiden Verdampfer über dem Verflüssiger liegen. Die beiden übereinander liegenden Trägerplatten sind mittels des haubenförmigen Abdeckgehäuses abgedeckt, die mit ihren bodenseitigen Rändern auf der unteren Trägerplatte aufsitzen. Die Zuführung der Kaltluft zum Innenraum des Schaltschrankes sind in den den beiden Verdampfern zugekehrten Wänden des haubenförmigen Abdeckgehäuses Luftdurchtrittsschlitze oder in der unteren Trägerplatte benachbart zu den Stirnseiten des Verflüssigers Luftdurchtrittsschlitze vorgesehen. Die Zuführung der Kaltluft in den Innenraum des Schaltschrankes kann je nach Anordnung der Kühlvorrichtung direkt oder über Zuführungsleitungen erfolgen.

Durch die Anordnung und Zuordnung der beiden Verdampfer zum Verflüssigen in zwei verschiedenen horizontalen Ebenen wird nicht nur eine kompakte Bauweise erreicht, sondern auch gleichzeitig für eine Verdunstung angefallenen Kondensats dadurch erreicht, dass das von den Verdampfern erzeugte Kondensat direkt auf den erwärmten Verflüssiger gelangt, dort verdunstet bzw. beim hohen Anfall von Kondensat kann zusätzlich eine Ableitung von nichtverdunstetem Kondensat über einen Überlauf bzw. in einer Auffangwanne erfolgen. Dadurch, dass die Kaltluftzuführungsstrecken von den Verdampfern zum Innenraum des Schaltschrankes längenveränderbar sind, ist eine Anpassung der Kühlvorrichtung bei dessen Einsatz als Dachgerät an verschiedene Schaltschrankbreiten möglich. Die technische Ausgestaltung besteht darin, dass die Kaltluftzuführungsstrecken als hutzenförmige Hauben ausgebildet sind, die in Durchbrechungen in der oberen Abdeckplatte des Schaltschrankes münden, wobei die hutzenartig bzw. haubenartig ausgebildeten Kaltluftzuführungsleitungen in ihren Längen veränderbar sind. Der Kondensatablauf erfolgt von den oben liegenden Verdampfern auf den Verflüssiger, indem dieser mit Kondensat berieselt wird. Durch Abstimmung der Druckverhältnisse ist ein kontrollierter Kondensatabschluss aus dem Innenkreislauf gewährleistet und es erfolgt eine Minimierung der Leckageströme aus der Umgebung in den Schaltschrank. Neben des Einsatzes der Kühlvorrichtung als Dachgerät kann die Kühlvorrichtung auch im Innenraum des Schaltschrankes angeordnet sein. Bevorzugterweise ist dann die Kühlvorrichtung als Baugruppe schubladenartig ausgebildet, so dass die Möglichkeit besteht, im Innenraum des Schaltschrankes, und zwar in Abhängigkeit von der jeweiligen Innenraumgröße, ein oder mehrere Kühlvorrichtungen anzuordnen und zwar an den jeweils gewünschten Stellen zwischen den einzelnen Baugruppen, die im Schaltschrank angeordnet sind.

Vorteilhafte Ausgestaltungen der Erfindung sind Gegenstand der Unteransprüche.

Das erfindungsgemäße Klimatisierungssystem wird beispielsweise anhand einer in den Zeichnungen dargestellten Kühlvorrichtung erläutert und zwar zeigen:
- Fig. 1: eine schaubildliche Ansicht der auf einem Schaltschrank angeordneten Kühlvorrichtung,
- Fig. 2: eine schaubildliche Ansicht der Kühlvorrichtung mit den verschiedenen Luftströmen,
- Fig. 3: eine Ansicht von oben auf die Kühlvorrichtung,
- Fig. 4: eine schaubildliche Explosionsdarstellung der Kühlvorrichtung mit den Verdampfer und die Verflüssiger tragenden Trägerplatten,
- Fig. 5: eine schaubildliche Explosionsdarstellung der Kühlvorrichtung von unten,
- Fig. 6: eine schaubildliche Explosionsdarstellung der Kühlvorrichtung mit abgehobenem haubenförmigen Abdeckgehäuse in einer seitlichen Ansicht,

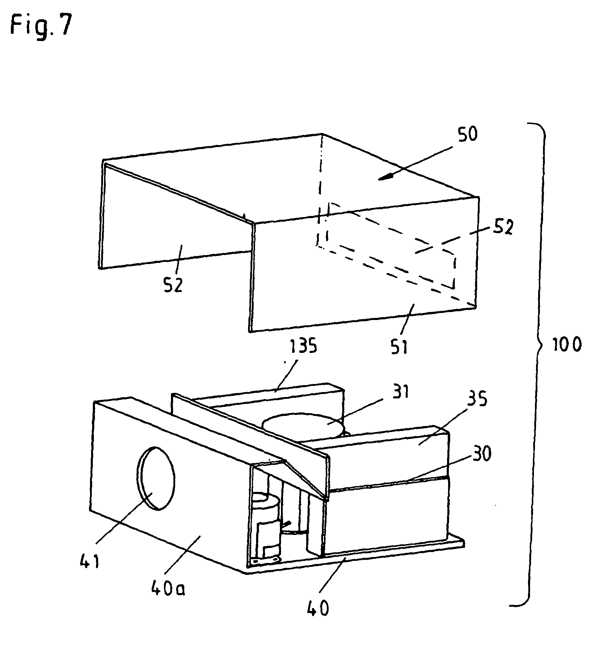

- Fig. 7: eine schaubildliche Explosionsdarstellung der Kühlvorrichtung mit abgehobenem haubenartigen Abdeckgehäuse, in einer rückwärtigen Ansicht und
- Fig. 8A und 8B: schaubildliche Ansichten von auf dem Dach von Schaltschränken angeordneten Kühlvorrichtungen mit haubenartigen Kaltluftzuführungsleitungen in verschiedenen Größen.

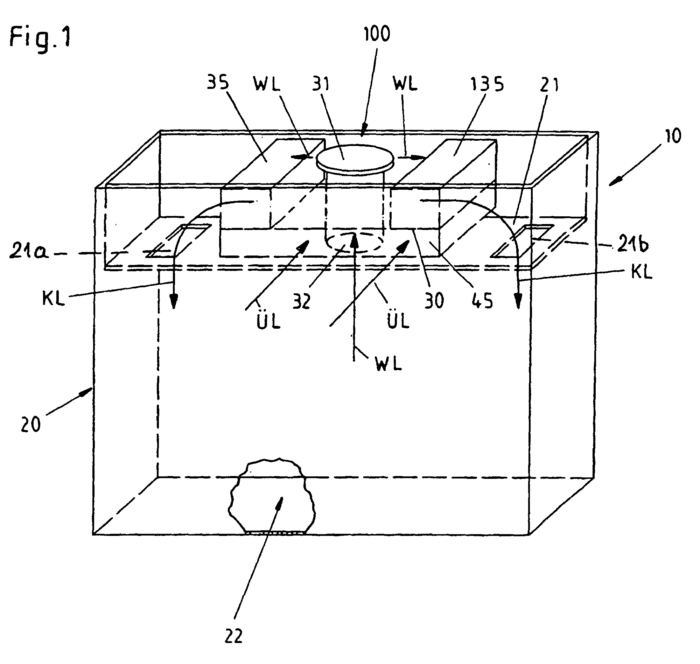

Das erfindungsgemäße Klimatisierungssystem 10 umfasst eine Kühlvorrichtung 100 entsprechend der in Fig. 1, 2 und 3 sowie Fig. 4 gezeigten Ausgestaltung. Wie Fig. 1 zeigt, ist die Kühlvorrichtung 100 auf der oberen Abdeckplatte 21 eines Schaltschrankes 20 angeordnet. Der Schaltschrankinnenraum ist bei 22 angedeutet.

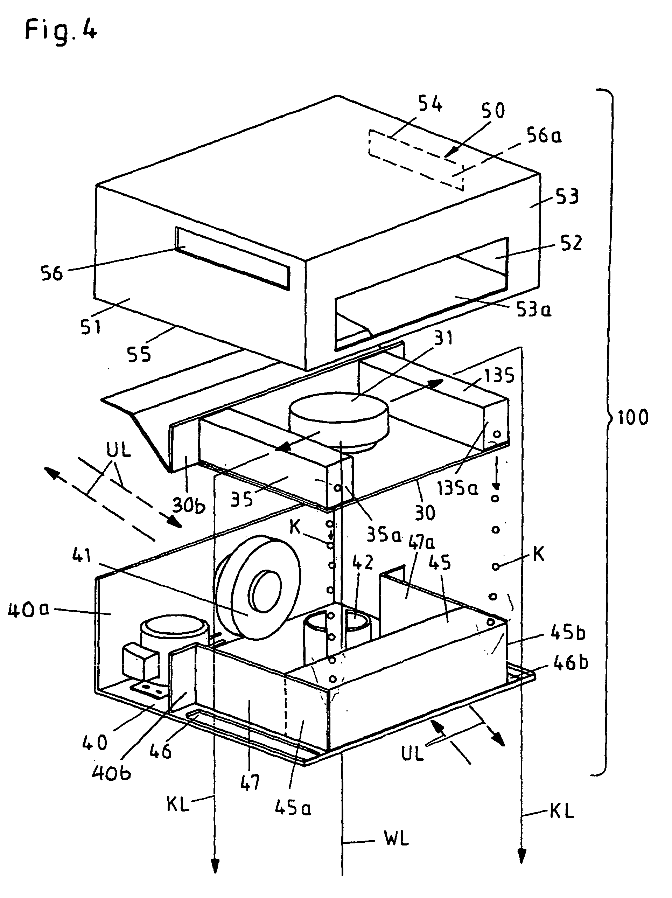

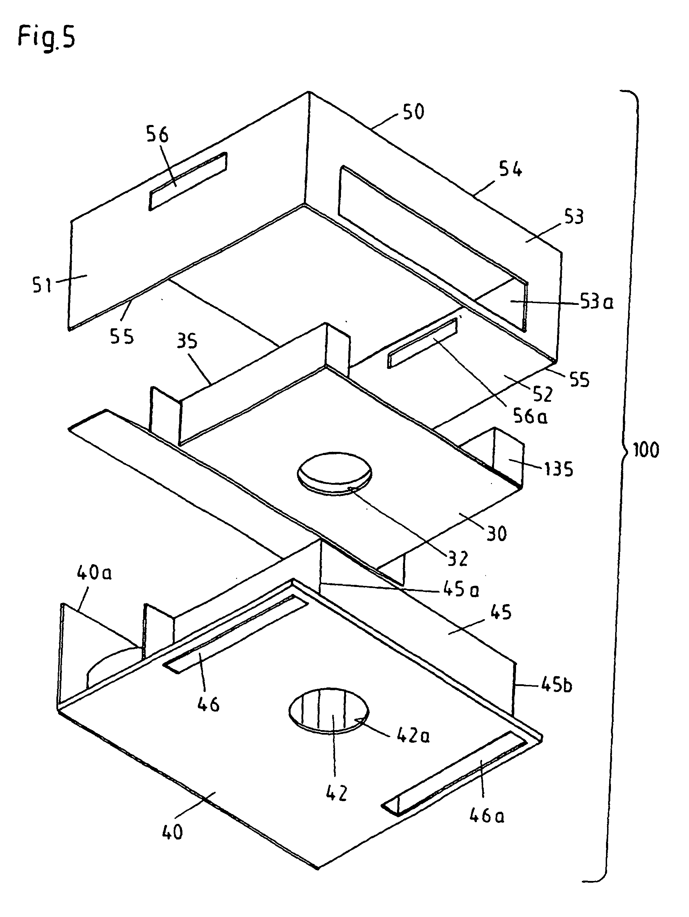

Die Kühlvorrichtung 100 besteht aus zwei übereinander liegenden und im Abstand voneinander angeordneten Trägerplatten 30, 40, die von einem haubenförmigen Abdeckgehäuse 50 abgedeckt bzw. umschlossen sind. Das haubenförmige Abdeckgehäuse 50 ist etwa kastenförmig ausgebildet und weist nach einer bevorzugten Ausführungsform gemäß Fig. 4 und 5 zwei sich gegenüberliegende Seitenwände 51, 52 und eine Vorderwand 53 mit einer Durchbrechung 53a auf. Obenseitig wird das haubenförmige Abdeckgehäuse 50 mittels einer oberen Abdeckplatte 54 abgedeckt. Mit seinen bodenseitigen Kanten/Rändern 55 sitzt das haubenförmige Abdeckgehäuse 50 auf der unteren Trägerplatte 40 auf. In den sich gegenüberliegenden Seitenwänden 51, 52 des haubenförmigen Abdeckgehäuses 50 sind Luftdurchtrittsschlitze 56, 56a ausgebildet. Die Rückwand des haubenförmigen Abdeckgehäuses 50 wird gebildet durch eine an der unteren Trägerplatte 40 vorgesehene Rückwand 40a, so dass ein geschlossenes kastenförmiges Gehäuse erhalten wird, welches die Kühlvorrichtung 100 aufnimmt.

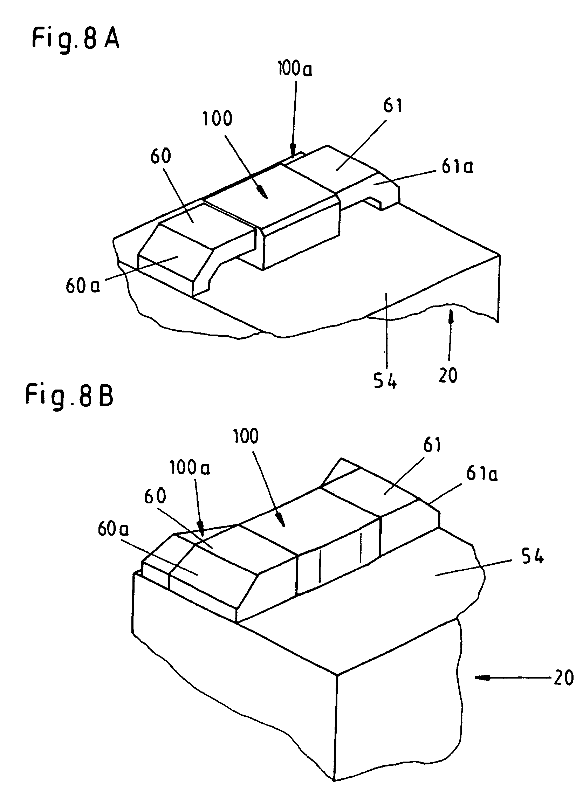

Die obere Trägerplatte 30 ist mit einer mittigen Durchbrechung 32, die auch außermittig angeordnet sein kann, versehen (Fig. 1, 4 und 5). Auf der oberen Trägerplatte 30 ist im Bereich dieser Durchbrechung 32 ein Gebläse 31, wie z. B. ein Radiallüfter, angeordnet. Zu beiden Seiten des Gebläses 31 sind im Abstand voneinander auf der oberen Trägerplatte 30 je ein Verdampfer 35, 135 angeordnet, denen die Warmluft WL aus dem Innenraum 22 des Schaltschrankes 20 vermittels des Gebläses 31 zugeführt wird. Die Anzahl der auf der oberen Trägerplatte 30 angeordneten Verdampfer 35, 135 ist nicht beschränkt auf nur zwei Verdampfer. Es besteht auch die Möglichkeit, oder mehrere Verdampfer gruppenweise zu beiden Seiten des Gebläses 31 anzuordnen (Fig. 1). Die Luftdurchtrittsschlitze 56, 56a in den Seitenwänden 51, 52 des haubenförmigen Abdeckgehäuses 50 sind in dem Bereich der beiden Verdampfer 35, 135 vorgesehen, so dass die Kaltluft KL direkt von den Verdampfern 35, 135 durch die Luftdurchtrittsschlitze 56, 56a hindurchströmen kann, um dem Innenraum 22 des Schaltschrankes 20 zugeführt zu werden (Fig. 8A, 8B). Die Zuführung der Kaftluft KL von den beiden Verdampfern 35, 135 in dem Innenraum 22 des Schaltschrankes 20 erfolgt über in der oberen Abdeckplatte 21 des Schaltschrankes 20 vorgesehene schlitzförmige Öffnungen bzw. Durchbrechungen 21a, 21b (Fig. 1).

Die Erfindung ist nachstehend mit einer Kühlvorrichtung 100 mit zwei Verdampfern 35, 135 als Ausführungsbeispiel beschrieben.

Die untere Trägerplatte 40 ist mittig oder außermittig mit einer Durchbrechung 42a versehen, in die ein senkrecht geführter Zuführungsstutzen 42 mündet (Fig. 4 und 5). Dieser Zuführungsstutzen 42 mündet mit seinem freien Ende in die Durchbrechung 32 in der oberen Trägerplatte 30, so dass über den Zuführungsstutzen 42 der Innenraum 22 des Schaltschrankes 20 mit dem Innenraum verbunden ist, der von der oberen Trägerplatte 30 mit seinen beiden Verdampfern 35, 135 begrenzt bzw. gebildet wird, so dass die Warmluft WL in den Ansaugbereich des Verdampferlüfters 31 und über diesen zu den beiden Verdampfern 35, 135 geführt wird. Die Warmluft WL aus dem Innenraum 22 des Schaltschrankes 20 wird mittels des Gebläses 31 angesogen und den beiden Verdampfern 35, 135 zugeführt.

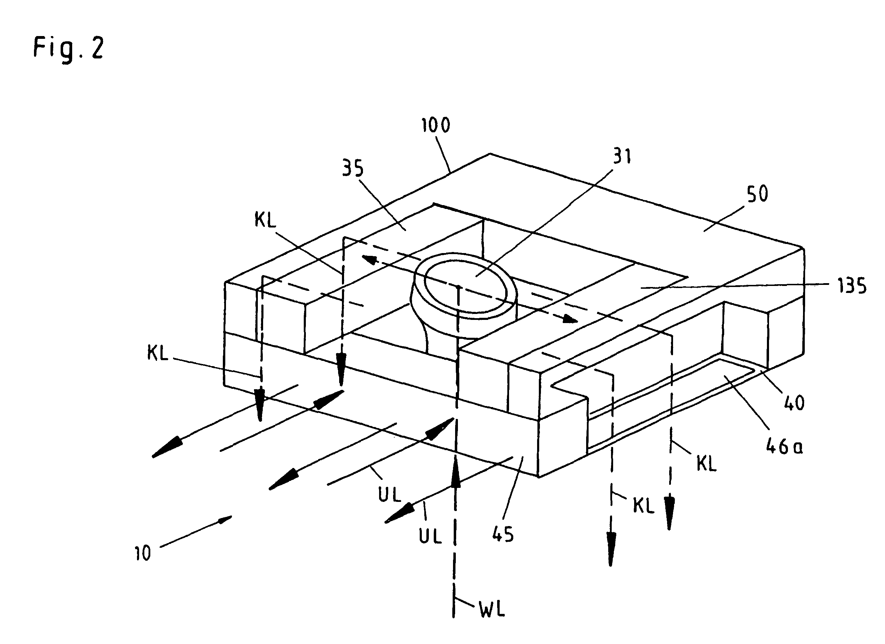

Die untere Trägerplatte 40 trägt ferner einen Verflüssiger 45, der mit einem Verflüssigerlüfter 41, der z. B. als Axiallüfter ausgebildet ist, in Verbindung steht, so dass vermittels des Verflüssigerlüfters 41 Umgebungsluft UL dem Verflüssiger 45 zugeführt und aus diesem wieder abgeleitet wird. Der Strömungsverlauf der dem Verflüssiger 45 zugeführten Umgebungsluft UL ist in Fig. 1 und 2 mit Pfeilen angedeutet. Der Verflüssigerlüfter 41 ist in der Rückwand 40a der unteren Trägerplatte 40 angeordnet (Fig. 4). Es besteht somit die Möglichkeit, Umgebungsluft UL von hinten anzusaugen oder nach hinten auszublasen (Verflüssigerkreislauf).

Der Verflüssiger 45 auf der unteren Trägerplatte 40 ist quer zu den beiden Verdampfern 35, 135 auf der oberen Trägerplatte angeordnet.

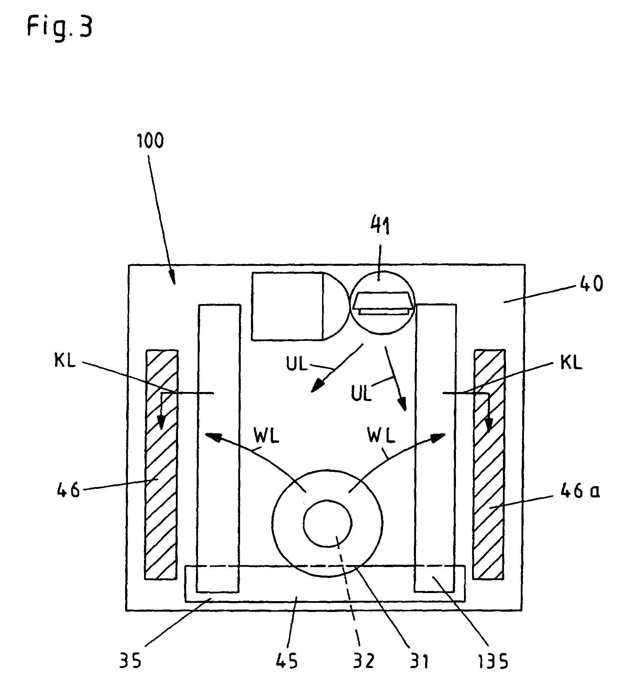

Wie insbesondere die Fig. 4 und 5 zeigen, ist die obere Trägerplatte 30 über die untere Trägerplatte 40 derart angeordnet, dass die beiden Verdampfer 35, 135 zur Kondensatverdunstung mit ihren beiden vorderen Bereichen 35a, 135a oberhalb des Verflüssigers 45 zu liegen kommen. Die obere Trägerplatte 30 ist bevorzugterweise gegenüber der unteren Trägerplatte 40 derart bemessen, dass die vorderen Bereiche 35a, 135a der beiden Verdampfer 35, 135 über dem Verflüssiger 45 liegen (Fig. 2 und 3).

Die Zuführung der Kaltluft KL von den beiden Verdampfern 35, 135 zum Innenraum 22 des Schaltschrankes 20 erfolgt bei der in Fig. 1 gezeigten Ausführungsform über Luftdurchtrittsschlitze 56, 56a, in den den beiden Verdampfern 35, 135 zugekehrten Wänden 51, 52 des haubenförmigen Abdeckgehäuses 50.

Eine weitere Ausführungsform gemäß Fig. 4 sieht vor, dass die Kaltluft KL über in der unteren Trägerplatte 40 benachbart zu den Stirnseiten 45a, 45b des Verflüssigers 45 vorgesehene Luftdurchtrittsschlitze 46, 46a dem Innenraum 22 des Schaltschrankes 20 zugeführt wird. Die Ausbildung der Luftdurchtrittsschlitze 46, 46a in der unteren Trägerplatte 40 ist derart, dass der Verflüssiger 45 eine geringe Länge gegenüber der Länge der unteren Trägerplatte 40 aufweist, so dass Plattenabschnitte ausgebildet werden, in denen die Luftdurchtrittsschlitze 46, 46a vorgesehen werden können. Wie Fig. 4 zeigt, sind im Bereich der Luftdurchtrittsschlitze 46, 46a auf der unteren Trägerplatte 40 seitliche Wände 47, 47a vorgesehen, die zusammen mit dem dem vorderen Bereich angeordneten Verflüssiger 45 einen Innenraum bilden, der bei auf die untere Trägerplatte aufgesetzter oberen Trägerplatte 30 abgedeckt wird. Die Kühlvorrichtung 100 ist dann auf der oberen Abdeckplatte 21 des Schaltschrankes 20 derart angeordnet, dass die Luftdurchtrittsschlitze 56, 56a in der unteren Trägerplatte 40 mit entsprechenden Öffnungen bzw. Durchbrechungen 21a, 21b in der oberen Abdeckplatte 21 des Schaltschrankes 20 korrespondieren.

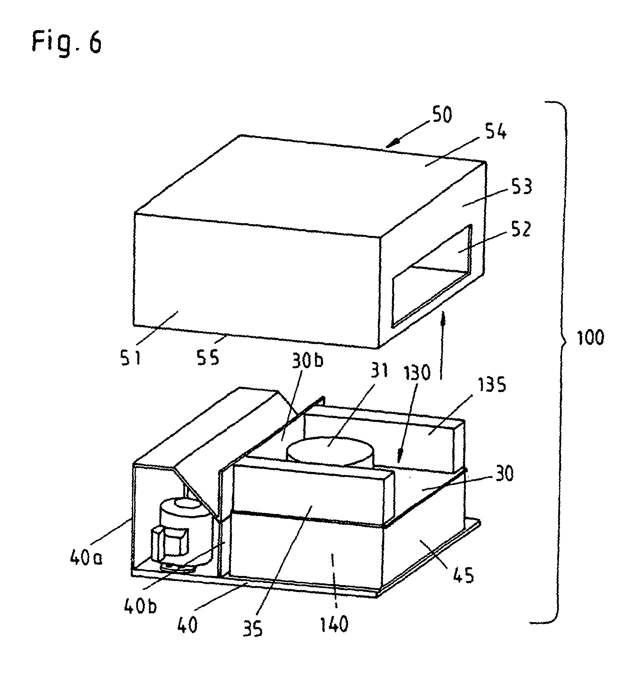

Das haubenförmige Abdeckgehäuse 50 übergreift die beiden übereinander liegend angeordneten Trägerplatten 30, 40 derart, dass die Durchbrechung 53a in der Vorderwand 53 des haubenförmigen Abdeckgehäuses 50 im Bereich des Verflüssigers 45 liegt, so dass Umgebungsluft UL dem Verflüssiger 45 zugeführt werden kann (Fig. 6).

Bevorzugterweise werden in der von der oberen Trägerplatte 30 gebildeten Kammer 130 und der von der unteren Trägerplatte 40 gebildeten Kammer 140 in etwa gleiche Druckverhältnisse aufrechterhalten. Dies erfolgt durch entsprechende Steuerung des Gebläses 31 und des Verflüssigerlüfters 41. Am Boden des Verflüssigers 45 ist nach einer weiteren Ausgestaltung eine in der Zeichnung nicht dargestellte Kondensatauffangwanne mit einer Ablaufrinne vorgesehen. Das Kondensat der beiden Verdampfer 35, 135 wird gesammelt und nach vorn auf den Verflüssiger 45 geleitet, wo das Kondensat verdunsten kann. Es erfolgt eine Abstimmung der Druckverhältnisse im Verdampfer- und Verflüssigerraum.

Die Kammer 130 auf der oberen Trägerplatte 30 wird gebildet von den beiden Verdampfern 35, 135, dem oberen Abschnitt 53b, der Vorderwand 53 des haubenförmigen Abdeckgehäuses 50 und einer an der Trägerplatte 30 rückseitig angeordneten Rückwand 30b. Die Kammer 140 auf der unteren Trägerplatte 40 wird gebildet von dem vorderen Verflüssiger 45, den seitlichen mit der Trägerplatte 40 verbundenen Seitenwänden 47, 47a und der Trägerplattenrückwand 40a bzw. einer Zwischenwand 40b (Fig. 4 und 6), wohingegen sich die Trägerplattenrückwand 40a über beide Kammern 130, 140 erstreckt, d. h. die Höhe der Trägerplattenrückwand 40a entspricht der Höhe der beiden übereinanderliegenden Kammern 130, 140.

Die Kühlvorrichtung 100 ist, wie in den Fig. 1, 8a und 8b dargestellt, als Dachgerät 100a ausgebildet, wobei die obere Abdeckplatte 21 des Schaltschrankgehäuses 20 mit einer entsprechenden Anzahl von Öffnungen für den Anschluss des Warmluftzuführungsstutzen 42 und für die Kaltiuftzuführung zum Innenraum 22 des Schaltschrankes 20 versehen ist.

Wie Fig. 8a und 8b zeigen, sind die in den sich gegenüberliegenden Seitenwänden 51, 52 des haubenförmigen Abdeckgehäuses 50 für die beiden Trägerplatten 30, 40 vorgesehenen Durchbrechungen bzw. Luftdurchtrittsschlitze 56, 56a für die Kaltluft KL mit seitlichen an dem Abdeckgehäuse 50 angeordneten hutzenartigen Kaltluftzuführungskanälen 60, 60a versehen, die an ihren Enden abgewinkelte Kanalabschnitte 60a, 61a aufweisen, die in Öffnungen in der oberen Abdeckplatte 21 des Schaltschrankgehäuses münden. Diese Kaltluftzuführungskanäle 60, 61 sind in ihren Längen veränderbar ausgebildet, so dass eine Anpassung an jede Schaltschrankbreite möglich ist.

Gemäß der Erfindung ist unter Hinzuziehung der Fig. 4 das Klimatisierungssystem in Verbindung mit der Kühlvorrichtung 100 derart ausgebildet, dass Warmluft WL aus dem Innenraum 22 des Schaltschrankes 20 mittels des Gebläses 31 angesogen und mindestens zwei, vorzugsweise in der Ebene des Gebläses 31 liegenden Verdampfern 35, 135 zugeführt wird. Von diesen Verdampfern 35, 135 wird Kaltluft KL in den Innenraum 22 des Schaltschrankes 20 geleitet. Unterhalb der Verdampfer 35, 135 ist der Verflüssiger 45 derart angeordnet, dass die Verdampfer 35, 135 mit einem Abschnitt bzw. mit ihren vorderen Bereichen 35a, 135a oberhalb des Verflüssigers zu liegen kommt, so dass von den Verdampfern 35, 135 abgegebenes Kondensat K auf den Verflüssiger 45 tropft und verdampft bzw. verdunstet. Dem Verflüssiger 45 wird Umgebungsluft UL zugeführt, wobei die Kaltluftzuführungsstrecken zum Innenraum 22 des Schaltschrankes 20 längenveränderbar sind. Die Führung der Warmluft WL, der Kaltluft KL, der Umgebungsluft UL und des Kondensats K ist vermittels Pfeilen in Fig. 4 angedeutet.

Das erfindungsgemäße Klimatisierungssystem mit seiner Kühlvorrichtung 100 ist überall dort einsetzbar, wo aus einem Innenraum, in dem durch Bauteile Wärme erzeugt wird, die Wärme abgeleitet und Kaltluft zugeführt werden muss.

Die Kühlvorrichtung 100 ist im Innenraum des Schaltschrankes 20 anordbar, als Dachgerät auf einem Schaltschrank 20 einsetzbar, als Einschubgerät im Innenraum eines Schaltschrankes 20 und als Sockelgerät verwendbar; bevorzugterweise weist die Kühlvorrichtung 100 eine flache Bauweise auf.

## Patentansprüche

1. Klimatisierungssystem für Schränke zur Aufnahme von Steuerungsund Automationssysteme sowie für die Netzwerktechnik, insbesondere Schaltschränke mit einer Kühlvorrichtung, wobei Warmluft (WL) aus dem Innenraum (22) des Schaltschrankes (20) mittels eines Gebläses (31) angesogen und einem Verdampfer (35, 135) zugeführt wird, von dem Kaltluft (KL) in den Innenraum (22) des Schaltschrankes (20) geleitet wird, wobei unterhalb des Verdampfers (35, 135) ein Verflüssiger (45) angeordnet ist, dem Umgebungsluft (UL) zugeführt wird, wobei die Kaltluftzuführungsstrecken zum Innenraum (22) des Schaltschrankes (20) in ihren Längen konstant oder längenveränderbar sind,
**dadurch gekennzeichnet,**
**dass** das Klimatisierungssystem mehrere, in der Ebene des Gebläses (31) liegende Verdampfer (35, 135) aufweist, wobei unterhalb der Verdampfer (35, 135) der Verflüssiger (45) derart angeordnet ist, dass die in einem Abstand voneinander angeordneten Verdampfer (35, 135) mit einem Abschnitt bzw. mit ihren vorderen Bereichen (35a, 135a) oberhalb des Verflüssigers (45) zu liegen kommen, so dass das von den Verdampfem in deren oberhalb des Verflüssigers (45) liegenden Bereichen (35a, 135a) abgegebene Kondensat (K) auf den Verflüssiger (45) tropft und verdampft bzw. verdunstet.

2. Klimatisierungssystem nach Anspruch 1,
**dadurch gekennzeichnet,**
- **dass** die Kühlvorrichtung (100) aus einer oberen Trägerplatte (30), einer unteren Trägerplatte (40) und einem beide Trägerplatten (30, 40) abdeckenden, kastenförmigen haubenartigen Abdeckgehäuse (50) besteht,
- **dass** auf der oberen Trägerplatte (30) mit einer mittigen oder außermittigen Durchbrechung (32) im Bereich der Durchbrechung (32) ein Gebläse (31), wie z. B. Radiallüfter, und zu beiden Seiten des Gebläses (31) im Abstand voneinander je ein Verdampfer (35, 135) angeordnet sind,
- **dass** die untere Trägerplatte (40) mittig oder außermittig mit einem in die Durchbrechung (32) in der oberen Trägerplatte (30) mündenden mit dem Innenraum (22) des Schaltschrankes (20) in Verbindung stehenden Luftzuführungsstutzen (42) für die Zuführung der Warmluft (WL) aus dem Innenraum (22) des Schaltschrankes (20) zu den beiden Verdampfern (35, 135) versehen ist und einen Verflüssiger (45) trägt, dem ein Verflüssigerlüfter (41), z. B. Axiallüfter, an der an der unteren Trägerplatte (40) vorgesehenen Rückwand (40a) zugeordnet ist, und der quer zu den beiden Verdampfern (35, 135) liegend ist und dem vermittels des Verflüssigerlüfters (41) Umgebungsluft (UL) zugeführt und abgeleitet wird,
- **dass** die obere Trägerplatte (30) über der unteren Trägerplatte (40) derart angeordnet ist, dass die beiden Verdampfer (35, 135) zur Kondensatverdunstung mit ihren beiden vorderen Bereichen (35a, 135a) oberhalb des Verflüssigers (45) zu liegen kommen, wobei die obere Trägerplatte (30) gegenüber der unteren Trägerplatte (40) derart bemessen ist, dass die vorderen Bereiche (35a, 135a) der beiden Verdampfer (35, 135) über den Verflüssiger (45) liegen,
- **dass** die beiden übereinander liegenden Trägerplatten (30, 40) mittels des haubenförmigen Abdeckgehäuses (50) abgedeckt sind, die mit ihren bodenseitigen Rändern (55) auf der unteren Trägerplatte (40) aufsitzt und
- **dass** zur Zuführung der Kaltluft (KL) zum Innenraum (22) des Schaltschrankes (20)
a.) in den den beiden Verdampfern (35, 135) zugekehrten Wänden (51, 52) des haubenförmigen Abdeckgehäuses (50) Luftdurchtrittsschlitze (56, 56a) oder
b.) in der unteren Trägerplatte (40) benachbart zu den Stirnseiten (45a, 45b) des Verflüssigers (45) Luftdurchtrittsschlitze (46, 46a)
vorgesehen sind.

3. Klimatisierungssystem nach einem der Ansprüche 1 und 2,
**dadurch gekennzeichnet,**
**dass** in der von der oberen Trägerplatte (30) gebildeten Kammer (130) und der von der unteren Trägerplatte (40) gebildeten Kammer (140) in Verbindung mit dem haubenförmigen Abdeckgehäuse (50) annähernd gleiche Druckverhältnisse aufrechterhalten werden.

4. Klimatisierungssystem nach einem der Ansprüche 1 bis 3,
**dadurch gekennzeichnet,**
**dass** die Kammer (130) auf der oberen Trägerplatte (30) von den beiden Verdampfern (35, 135), dem oberen Abschnitt (53b) der Vorderwand (53) des haubenförmigen Abdeckgehäuses (50) und einer an der Trägerplatte (30) rückseitig angeordneten Rückwand (30b) und die Kammer (140) auf der unteren Trägerplatte (40) von dem vorderen Verflüssiger (45), den seitlichen, mit der Trägerplatte (40) verbundenen Seitenwänden (47, 47a) und der Trägerplattenrückwand (40a) bzw. einer Zwischenwand (40b) gebildet werden, wobei sich die Trägerplattenrückwand (40a) über beide Kammern (130, 140) erstreckt, so dass die Höhe der Trägerplattenrückwand (40a) der Höhe der beiden übereinander liegenden Kammern (130, 140) entspricht.

5. Klimatisierungssystem nach einem der Ansprüche 1 bis 4,
**dadurch gekennzeichnet,**
**dass** die Luftdurchtrittsschlitze (56, 56a) in den Seitenwänden (51, 52) des haubenförmigen Abdeckgehäuses (50) im Bereich der beiden Verdampfer (35, 135) derart vorgesehen sind, dass die Kaltluft (KL) direkt von den Verdampfern (35, 135) durch die Luftdurchtrittsschlitze (56, 56a) hindurchströmt, um dem Innenraum (22) des Schaltschrankes (20) zugeführt zu werden.

6. Klimatisierungssystem nach einem der Ansprüche 1 bis 5,
**dadurch gekennzeichnet,**
**dass** die Kaltluft (KL) von den beiden Verdampfern (35, 135) in den Innenraum (22) des Schaltschrankes (20) über in der oberen Abdeckplatte (21) des Schaltschrankes (20) vorgesehene schlitzförmige Öffnungen bzw. Durchbrechungen (21a, 21b) erfolgt.

7. Klimatisierungssystem nach einem der Ansprüche 1 bis 6,
**dadurch gekennzeichnet,**
**dass** die Kühlvorrichtung (100) am Boden des Verflüssigers (45) eine Kondensatauffangwanne mit einer Ablaufrinne aufweist.

8. Klimatisierungssystem nach einem der Ansprüche 1 bis 7,
**dadurch gekennzeichnet,**
**dass** das Kondensat der beiden Verdampfer (35, 135) gesammelt und nach vorn auf den Verflüssiger (45) geleitet wird.

9. Klimatisierungssystem nach einem der Ansprüche 1 bis 8,
**dadurch gekennzeichnet,**
**dass** die Kühlvorrichtung (100) als Dachgerät (100a) ausgebildet ist, wobei die obere Abdeckplatte (21) des Schaltschrankgehäuses (20) mit Öffnungen für den Anschluss des Warmluftzuführungsstutzens (42) und für die Kaltluftzuführung zum Innenraum (22) des Schaltschrankes (20) versehen ist.

10. Klimatisierungssystem nach Anspruch 9,
**dadurch gekennzeichnet,**
**dass** die in den sich gegenüberliegenden Seitenwänden (51, 52) des haubenförmigen Abdeckgehäuses (50) für die beiden Trägerplatten (30, 40) vorgesehenen Austrittsdurchbrechungen (56, 56a) für die Kaltluft (KL) mit seitlichen an dem Abdeckgehäuse (50) angeordneten haubenförmigen Kaltluftzuführungskanälen (60, 61) versehen sind, die an ihren Enden abgewinkelte Kanalabschnitte (60a, 61a) aufweisen, die in Öffnungen in der oberen Abdeckplatte (21) des Schaltschrankgehäuses (20) münden.

11. Klimatisierungssystem nach Anspruch 10,
**dadurch gekennzeichnet,**
**dass** die Kaltluftzuführungskanäle (60, 61) in ihren Längen veränderbar ausgebildet sind.

12. Klimatisierungssystem nach einem der Ansprüche 1 bis 8,
**dadurch gekennzeichnet,**
**dass** die Kühlvorrichtung (100) als Einschubgerät ausgebildet und im Innenraum (22) des Schaltschrankes (20) angeordnet ist.

13. Klimatisierungssystem nach einem der Ansprüche 1 bis 8,
**dadurch gekennzeichnet,**
**dass** die Kühlvorrichtung (100) als Dachgerät ausgebildet und auf der oberen Abdeckplatte (21) des Schaltschrankes (20) angeordnet ist.

14. Klimatisierungssystem nach einem der Ansprüche 1 bis 8,
**dadurch gekennzeichnet,**
**dass** die Kühlvorrichtung (100) als Sockelgerät ausgebildet und im Bodenbereich des Schaltschrankes (20) angeordnet ist.

15. Klimatisierungssystem nach einem der Ansprüche 1 bis 14,
**dadurch gekennzeichnet,**
**dass** die Kühlvorrichtung (100) eine flache Bauweise aufweist.

## Claims

1. Air-conditioning system for cabinets to receive control and automation systems as well as networking, especially switch cabinets with a cooling device, wherein warm air (WL) is sucked in from the interior (22) of the switch cabinet (20) by means of a blower (31) and fed to an evaporator (35, 135) from which cold air (KL) is fed into the interior (22) of the switch cabinet (20), wherein arranged below the evaporator (35, 135) is a condenser (45) to which ambient air (UL) is fed, wherein the cold air supply sections to the interior (22) of the switch cabinet (20) are constant in their lengths or variable in length,
**characterised in**
**that** the air-conditioning system has evaporators (35, 135) lying in the plane of the blower (31), wherein below the evaporators (35, 135) the condenser (45) is arranged such that the evaporators (35, 135) located at a distance from one another come to lie with one section or with their front regions (35a, 135a) above the condenser (45) so that the condensate (K) delivered by the evaporators in their regions (35a, 135a) above the condenser (45) drips onto the condenser (45) and evaporates or vaporises.

2. The air-conditioning system according to claim 1,
**characterised in**
- **that** the cooling device (100) consists of an upper carrier plate (30), a lower carrier plate (40) and a box-shaped, hood-like covering housing (50) covering both carrier plates (30, 40),
- **that** a blower (31) such as a radial fan for example is arranged on the upper carrier plate (30) having a central or eccentric opening (32) in the area of the opening (32) and respectively one evaporator (35, 135) is arranged on both sides of the blower (31) at a distance from one another,
- **that** the lower carrier plate (40) is provided centrally or eccentrically with an air supply connecting piece (42) which opens into the opening (32) in the upper carrier plate (30) and is in communication with the interior (22) of the switch cabinet (20) for the supply of warm air (WL) from the interior (22) of the switch cabinet (20) to the two evaporators (35, 135) and carries a condenser (45) to which is assigned a condenser fan (41), e.g. an axial fan, on the rear wall (40a) provided on the lower carrier plate (40), and which lies transversely to both evaporators (35, 135) and to which ambient air (UL) is fed and from which it is drawn off by means of the condenser fan (41),
- **that** the upper carrier plate (30) is arranged over the lower carrier plate (40) such that the two evaporators (35, 135) for evaporating the condensate come to lie with their two front regions (35a, 135a) above the condenser (45) wherein the upper carrier plate (30) is dimensioned compared with the lower carrier plate (40) such that the front regions (35a, 135a) of the two evaporators (35, 135) lie above the condenser (45),
- **that** the two carrier plates (30, 40) lying one above the other are covered with a hood-shaped covering housing (50) which sits with its bottom edges (55) on the lower carrier plate (40) and
- **that** for supplying the cold air (KL) to the interior (22) of the switch cabinet (20) there are provided
a) air opening slits (56, 56a) in the walls (51, 52) of the hood-shaped covering housing (50) facing the two evaporators (35, 135)
b) air opening slits (46, 46a) in the lower carrier plate (40) adjacent to the front sides (45a, 45b) of the condenser (45).

3. The air-conditioning system according to any one of claims 1 and 2,
**characterised in**
**that** in the chamber (130) formed by the upper carrier plate (30) and the chamber (140) formed by the lower carrier plate (40) in association with the hood-shaped covering housing (50), approximately the same pressure relationships are maintained.

4. The air-conditioning system according to any one of claims 1 to 3,
**characterised in**
**that** the chamber (130) on the upper carrier plate (30) is formed by the two evaporators (35, 135), the upper section (53b) of the front wall (53) of the hood-shaped covering housing (50) and a rear wall (30b) arranged on the carrier plate (30) at the back and the chamber (140) on the lower carrier plate (40) is formed by the front evaporator (45), the lateral side walls (47, 47a) connected to the carrier plate (40) and the carrier-plate rear wall (40a) or an intermediate wall (40b), wherein the carrier-plate rear wall (40a) extends over both chambers (130, 140) such that the height of the carrier-plate rear wall (40a) corresponds to the height of the two chambers (130, 140) lying one above the other.

5. The air-conditioning system according to any one of clairns 1 to 4,
**characterised in**
**that** the air opening slits (56, 56a) in the side walls (51, 52) of the hood-shaped covering housing (50) in the area of the two evaporators (35, 135) are provided such that the cold air (KL) flows directly from the evaporators (35, 135) through the air opening slits (56, 56a) to be fed to the interior (22) of the switch cabinet (20).

6. The air-conditioning system according to any one of claims 1 to 5,
**characterised in**
**that** the cold air (KL) from the two evaporators (35, 135) is fed into the interior (22) of the switch cabinet (20) via slit-shaped apertures or openings (21a, 21b) provided in the upper cover plate (21) of the switch cabinet (20).

7. The air-conditioning system according to any one of claims 1 to 6,
**characterised in**
**that** the cooling device (100) at the bottom of the condenser (45) has a condensate collecting tray with a run-off channel.

8. The air-conditioning system according to any one of claims 1 to 7,
**characterised in**
**that** the condensate from the two evaporators (35, 135) is collected and fed towards the front onto the condenser (45).

9. The air-conditioning system according to any one of claims 1 to 8,
**characterised in**
**that** the cooling device (100) is constructed as a roof device (100a) wherein the upper cover plate (21) of the switch cabinet housing (20) is provided with openings for the connection of the warm-air supply connecting piece (42) and for the cold air supply to the interior (22) of the switch cabinet (20).

10. The air-conditioning system according to claim 8,
**characterised in**
**that** the outlet openings (56, 56a) for the cold air (KL) provided in the opposing side walls (51, 52) of the hood-shaped housing (50) for the two carrier plates (30, 40) are provided with hood-shaped cold air supply channels (60, 61) arranged laterally on the covering housing (50), which have angled channel sections (60a, 61a) at their ends which open into openings in the upper cover plate (21) of the switch cabinet housing (20).

11. The air-conditioning system according to claim 10,
**characterised in**
**that** the cold air supply channels (60, 61) are constructed such that they are variable in length.

12. The air-conditioning system according to any one of claims 1 to 8,
**characterised in**
**that** the cooling device (100) is constructed as a plug-in device and is arranged in the interior (22) of the switch cabinet (20).

13. The air-conditioning system according to any one of claims 1 to 8,
**characterised in**
**that** the cooling device (100) is constructed as a roof device and is arranged on the upper cover plate (21) of the switch cabinet (20).

14. The air-conditioning system according to any one of claims 1 to 8,
**characterised in**
**that** the cooling device (100) is constructed as a socket unit and is arranged in the bottom of the switch cabinet (20).

15. The air-conditioning system according to any one of claims 1 to 14,
**characterised in**
**that** the cooling device (100) has a flat design.

## Revendications

1. Système de conditionnement d'air pour des armoires renfermant des systèmes de commande et d'automatisation ainsi que de gestion des réseaux informatiques, en particulier des armoires électriques comportant un dispositif de refroidissement, dans lequel l'air chaud (AC) est diffusé à l'extérieur de l'espace interne (22) de l'armoire électrique (20) au moyen d'un ventilateur (31) et introduit dans des évaporateurs (35,135), lesquels dirigent de l'air froid (AF) dans l'espace interne (22) de l'armoire électrique (20), dans lequel un condensateur (45) est disposé en dessous de l'évaporateur (35,135), dans lequel de l'air extérieur (AE) est introduit, dans lequel les conduites d'introduction d'air froid à l'intérieur de l'espace interne (22) de l'armoire électrique (20) présentent des longueurs
constantes,
**caractérisé en ce que**
le système de conditionnement d'air présente plusieurs évaporateurs (35,135) situés au niveau du ventilateur (31), dans lequel le condensateur (45) est disposé en dessous des évaporateurs (35,135) de telle sorte qu'une portion ou plutôt une région avant (35a, 135a) des évaporateurs (35,135) séparés l'une de l'autre par un espace soit amenée à reposer au dessus du condensateur (45), de telle sorte que le condensat (C) extrait par les évaporateurs dans leurs portions (35a, 135a) qui reposent au dessus du condensateur (45) coule goutte à goutte dans le condensateur (45) et s'évapore ou plutôt se volatilise.

2. Système de conditionnement d'air selon la revendication 1,
**caractérisé en ce que**
- le dispositif de refroidissement (100) est constitué d'une plaque de support supérieure (30), d'une plaque de support inférieure (40) et d'un couvercle de logement (50) en forme de boîtier de type capot qui recouvre une des deux plaques de support (30,40),
- sur la plaque de support supérieure (30) pourvue d'une ouverture (32) centrale ou excentrée, un ventilateur (31), comme par exemple un ventilateur radial, est disposé au niveau de l'ouverture (32) et des évaporateurs (35,135) sont disposés sur les deux côtés du ventilateur (31) à une certaine distance l'un de l'autre,
- la plaque de support inférieure (40) comporte en son centre ou à une position excentrée une conduite d'air (42) reliée avec l'espace interne (22) de l'armoire électrique (20), qui passe à travers l'ouverture (32) dans la plaque de support supérieure (30) pour conduire l'air chaud (AC) à l'extérieur de l'espace interne (22) de l'armoire électrique (20) vers les deux évaporateurs (35,135) et supporte un condensateur (45) auquel un ventilateur de condensation (41), par exemple un ventilateur axial, est coordonné sur la paroi dorsale (40a) prévue sous la plaque de support inférieure (40) et qui repose en travers des deux évaporateurs (35,135) et dans lequel de l'air extérieur (AE) est introduit et conduit au moyen du ventilateur de condensation (41),
- la plaque de support supérieure (30) est disposée au dessus de la plaque de support inférieure (40) de telle sorte que les deux portions avant (35a, 135a) des deux évaporateurs (35,135) destinés à l'évaporation du condensat soient amenés à reposer au dessus du condensateur (45), moyennant quoi les dimensions de la plaque de support supérieure (30) sont calculées par rapport à la plaque de support inférieure (40) de telle sorte que les portions avant (35a, 135a) des deux évaporateurs (35,135) reposent sur le condensateur (45),
- les deux plaques de support superposées l'une à l'autre (30,40) sont recouvertes d'un couvercle de logement (50) en forme de capot dont les bords inférieurs (55) reposent sur la plaque de support inférieure (40) et
- pour introduire l'air froid (AF) à l'intérieur de l'espace interne (22) de l'armoire électrique (20)
a) des fentes d'introduction de l'air (56,56a) sont prévues dans les parois opposées (51,52) du logement de couvercle (50) en forme de capot des deux évaporateurs (35,135) ou
b) des fentes d'introduction de l'air (46,46a) sont prévues sur la plaque de support inférieure (40) à une position adjacente aux côtés frontaux (45a, 45b) du condensateur (45).

3. Système de conditionnement d'air selon l'une des revendications 1 et 2, **caractérisé en ce que** des rapports de pression présumés identiques sont maintenus dans la chambre (130) formée par la plaque de support supérieure (30) et dans la chambre (140) formée par la plaque de support inférieure (40) en liaison avec le couvercle de logement (50) en forme de capot.

4. Système de conditionnement d'air selon une des revendications 1 à 3, **caractérisé en ce que** la chambre (130) est formée sur la plaque de support supérieure (30) par les deux évaporateurs (35,135), la portion supérieure (53b) de la paroi avant (53) du couvercle de logement en forme de capot(50) et une paroi dorsale (30b) disposée sur le côté arrière de la plaque de support (30) et **en ce que** la chambre (140) est formée sur la plaque de support inférieure (40) par l'avant du condensateur (45), les parois latérales (47,47a) reliées sur leurs côtés avec la plaque de support (40) et la paroi dorsale de la plaque de support (40a) ou plutôt une paroi intermédiaire (40b), moyennant quoi la paroi dorsale de la plaque de support (40a) s'étend sur les deux chambres (130, 140), de telle sorte que la hauteur de la paroi dorsale de la plaque de support (40a) corresponde à la hauteur des deux chambres superposées l'une à l'autre (130, 140).

5. Système de conditionnement d'air selon une des revendications 1 à 4, **caractérisé en ce que** les fentes d'introduction de l'air (56,56a) sont prévues dans les parois latérales (51,52) du couvercle de logement en forme de capot (50) au niveau des deux évaporateurs (35,135) de telle sorte que l'air froid (AF) soit introduit directement à partir des évaporateurs (35,135) en passant à travers les fentes d'introduction de l'air (56, 56a), de manière à remplir l'espace interne (22) de l'armoire électrique (20).

6. Système de conditionnement d'air selon une des revendications 1 à 5, **caractérisé en ce que** l'air froid (AF) provenant des deux évaporateurs (35,135) pénètre dans l'espace interne (22) de l'armoire électrique (20) par les ouvertures (21a 21b) en forme de fentes prévues dans la plaque supérieure de couvercle (21) de l'armoire électrique (20).

7. Système de conditionnement d'air selon une des revendications 1 à 6, **caractérisé en ce que** le dispositif de refroidissement (100) à la base du condensateur (45) présente un bac d'évacuation du condensat pourvu d'une gouttière d'évacuation.

8. Système de conditionnement de l'air selon une des revendications 1 à 7, **caractérisé en ce que** le condensat des deux évaporateurs (35,135) est collecté et dirigé vers l'avant du condensateur (45).

9. Système de conditionnement d'air selon une des revendications 1 à 8, **caractérisé en ce que** le dispositif de refroidissement (100) est conçu sous la forme d'un dispositif de couvercle (100a), dans lequel la plaque supérieure de couvercle (21) du logement de l'armoire électrique (20) est pourvue d'ouvertures permettant le raccordement de conduites d'introduction d'air chaud (42) et l'introduction d'air froid à l'intérieur de l'espace interne (22) de l'armoire électrique (20).

10. Système de conditionnement de l'air selon la revendication 9, **caractérisé en ce que** les orifices de sortie (56,56a) de l'air froid (AF) prévus sur les parois latérales opposées l'une à l'autre (51,52) du couvercle de logement en forme de capot (50) des deux plaques de support (30,40) sont pourvues de canaux d'introduction d'air froid (60,61) en forme de capot disposés sur les côtés du couvercle de logement (50), lesquels présentent à leurs extrémités des portions de canal recourbées (60a,61a), qui s'enfoncent dans les ouvertures sur la plaque supérieure de couvercle (21) du logement d'armoire électrique (20).

11. Système de conditionnement d'air selon la revendication 10, **caractérisé en ce que** les canaux d'introduction d'air froid (60,61) sont conçus à des longueurs réglables.

12. Système de conditionnement d'air selon une des revendications 1 à 8, **caractérisé en ce que** le dispositif de refroidissement (100) est conçu comme un dispositif enfichable et est disposé dans l'espace interne (22) de l'armoire électrique (20).

13. Système de conditionnement d'air selon une des revendications 1 à 8, **caractérisé en ce que** le dispositif de refroidissement (100) est conçu comme un dispositif de couvercle et est disposé sur la surface supérieure de couvercle (21) de l'armoire électrique (20).

14. Système de conditionnement d'air selon une des revendications 1 à 8, **caractérisé en ce que** le dispositif de refroidissement (100) est conçu comme un dispositif de socle et est disposé à la base de l'armoire électrique (20).

15. Système de conditionnement d'air selon une des revendications 1 à 14, **caractérisé en ce que** le dispositif de refroidissement (100) présente une configuration plate.
